# EUROPEAN PATENT APPLICATION

(11) **EP 1 804 377 A2**
(43) Date of publication of application: **04.07.2007**
(21) Application number: 06127134.2
(22) Date of filing: 22.12.2006
(51) Int. Cl.: H03H 9/64

(54) **SAW filter and portable terminal**

(30) Priority: 26.12.2005 JP 2005372657
(71) Applicant: NIHON DEMPA KOGYO CO., LTD., Shibuya-ku Tokyo Tokyo 151-8569 (JP)
(72) Inventor: Onzuka, Tatsunori Nihon Dempa Kogyo Co., Ltd., Sayama-shi Saitama 350-1321 (JP)
(74) Representative: TBK-Patent

(57) **Abstract**

In order to provide a SAW filter having a wide passband matching to the digital TV broadcast waves so as to be low-loss, and obtaining a sharp and large attenuation in the outside of the TV broadcast waves, a constant-K filter is composed of series arm SAW resonators (11,15) and parallel arm SAW resonators (12,16), and a circuit component is formed by connecting an inductor (14,21,22) for shifting a resonant point/antiresonant point to the series arm SAW resonator in series or to the parallel arm SAW resonator in parallel. A plurality of the circuit components are connected in a cascade connection to each other in a plurality of stages via inductors (19) for shifting the resonant point/antiresonant point.

## Description

### BACKGROUND OF THE INVENTION

### 1. FIELD OF THE INVENTION

The present invention relates to a surface acoustic wave (SAW) filter, especially to a surface acoustic wave (SAW) filter for a portable terminal with a digital TV broadcast receiver.

### 2. DESCRIPTION OF THE RELATED ART

Digital broadcast in Japan started in 2003. A digital broadcast service has started first in Europe in 2000. As the widespread use of portable terminals, various high value added services such as mailing functions or the like have started in addition to the telephoning function of the conventional portable terminal. With such a trend, portable terminal manufacturers of the world are investigating how to incorporate service to receive digital broadcast by transforming a conventional portable telephone into a portable terminal with a digital TV broadcast receiver, which carries a receiving function for digital TV broadcast in addition to a conventional portable telephone function.

Since the digital TV tuner module for this kind of portable terminals is used as a portable terminal, small power consumption, small size, and low profile are required in addition to requirements in specific features of the tuner itself such as receiving sensitivity, and moreover, it is required to prevent transmitted waves from interfering with received waves.

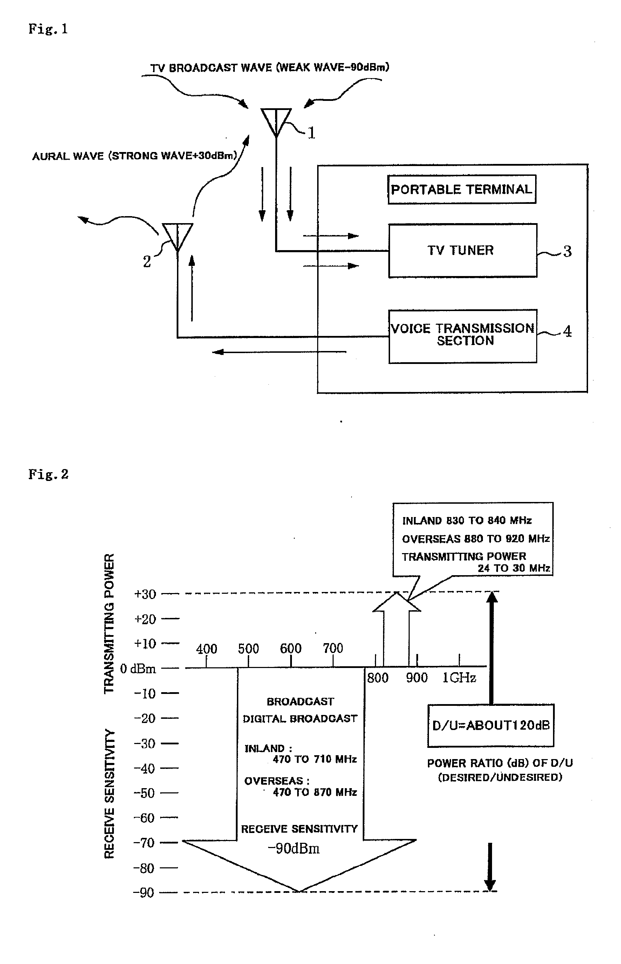

FIG. 1 shows a structural diagram of a transceiver section of a portable terminal with a digital TV broadcast receiver. In a portable terminal which can receive digital TV broadcast, two antennas, antenna 1 for receiving digital TV broadcast and antenna 2 for transmitting and receiving voice (and data) communication signals are closely arranged to each other, because of the difference in frequency bands between voice (and data) communication and TV broadcast. Since a digital TV broadcasting wave is usually a weak wave (- 90 dBm) here, the receiving sensitivity of a TV tuner module 3 is designed to be extremely high. On the other hand, the transmitted wave of a voice transmitting section 4 to transmit voice (and data) as a portable terminal launches an extremely intense wave (about +30 dBm) from the antenna 2. Accordingly, the transmitted wave for the voice (and data) communication reaches the TV broadcasting tuner module 3 via the antenna 1, thereby interfering with receiving of the TV broadcast. Therefore, in the portable terminal with a digital TV broadcast receiver, 120 dB of the D/U ratio (Desired/Undesired : power ration between a desired wave and un desired wave) as shown in FIG. 2 is said to be required.

In addition, the receiving band of the digital TV broadcasting in Japan is between 470 MHz and 710 MHz, while the transmitting band of voice communication is between 830 MHz and 840 MHz, which means they are very close to each other. In the digital broadcast in Europe, the digital TV broadcast receiving band is between 470 MHz and 870 MHz, while the transmitting band of the aural wave is between 880 MHz and 915 MHz, which also shows that they are very close to each other.

As above, when antennas are arranged closely to each other, and the bands of the transmitting wave and the receiving wave are close to each other as described above, the transmitted waves for voice or data communication surround a digital TV broadcast receiving antenna via antennas, which brings the problem of interfering with weak receiving waves of the TV broadcasting. In order to avoid the interference, a filter having steep attenuation is required to be provided at the base of the receiving antenna for digital TV broadcasting.

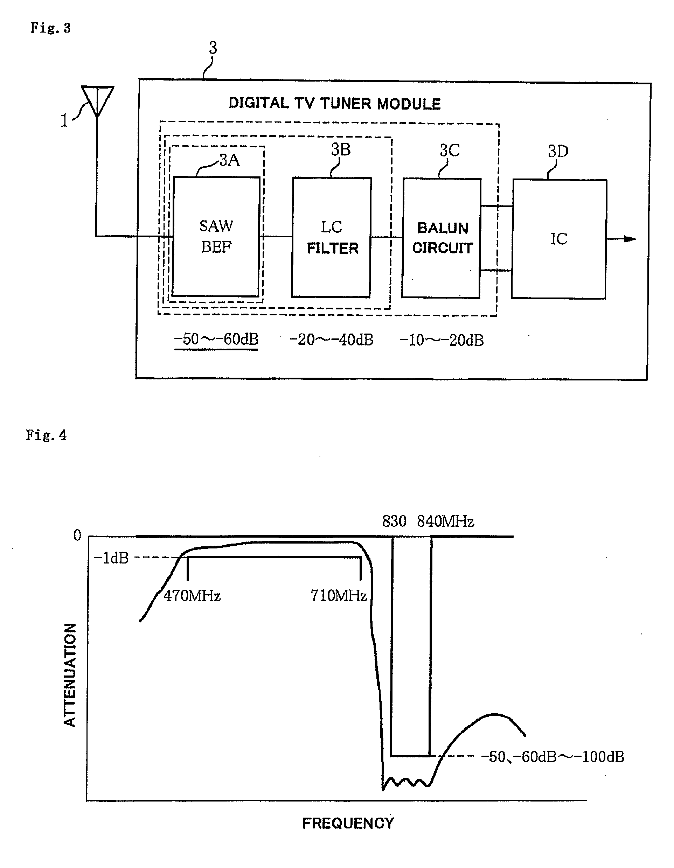

FIG. 3 shows a structural example of a receiving system of a TV tuner module for digital broadcast which satisfies the above-described requirement. A band elimination filter circuit (BEF circuit) 3A has steep suppression characteristics (-50 to -60 dB) on a transmitting wave frequency band launched from a transceiving antenna (not shown) of a portable telephone and captures the digital TV broadcasting waves received with the antenna 1 with low loss. An LC filter 3B includes a chip coil or a chip inductor and suppresses (-20 dB to -40 dB) the transmitting wave frequency band. A balun circuit 3C performs balance-to-unbalance conversion of TV broadcasting waves while suppressing (-10 dB to -20 dB) the transmitting wave frequency band. An IC circuit 3D converts a TV signal which is to be a modulated wave into a base band.

FIG. 4 shows examples of the characteristics required for the BEF circuit. The required characteristics are low loss in the receiving band of the digital TV broadcasting (small attenuation), and in the transmitting band for voice or data broadcasting, the attenuation should be steep and a large attenuation is required. The conventional technology includes a passive circuit using coils and capacitors, a dielectric filter utilizing high Q value of a dielectric substance, or a laminated chip part such as an LTCC or an HTCC which is prepared by arranging the above-described passive circuit on a pattern and further sintering it.

However, since it is a module mounted in a portable terminal, its area for mounting and the space thereof are limited, and the conventional technology has limitations in the down sizing and lower profiling of the module. In addition, since the receiving band of the digital TV broadcasting and the transmitting band of voice and data broadcasting come very close, a steep attenuation characteristic is required. In order to enhance the sharpness in attenuation, the conventional filter design theory requires two or more stages of connection of the resonance circuit being a component of the filter, which results in very large passband loss.

A surface acoustic wave (SAW) filter is a filter to realize small power consumption, small size, and low profile. However, it is difficult to obtain a wide passband and a large attenuation with a SAW filter structured by a SAW resonator only. Accordingly, a technology has been proposed, in which a ladder type filter structure using a plurality of the SAW resonators is prepared, inductors are further inserted between parallel arms and/or series arms of these SAW resonators in series and the resonant point and the antiresonant point in the respective SAW resonators are shifted so as to obtain a wide passband and a large suppression degree in the outside of the passband. (for instance, refer to Patent Documents 1 and 2).

The SAW filter using the above-described SAW resonator is considered to be adopted as a TV tuner module for digital broadcasting waves. However, since the transmitting band for voice communication and the receiving band for the digital TV broadcasting come very close, it is difficult to obtain a wide passband and a large attenuation degree in the outside of the passband with the conventional SAW filter, and moreover, it is difficult to obtain a D/U ratio (refer to FIG. 2) as large as 120 dB.
[Patent Document 1] Japanese Patent Application Laid-open No. Hei 5-183380
[Patent Document 2] Japanese Patent Application Laid-open No. 2004-135322

### SUMMARY OF THE INVENTION

An object of the present invention is to provide a SAW filter having a wide passband with low loss, matching the digital TV broadcasting waves, and being possible to obtain a steep and large attenuation in the outside of the TV wave band.

A SAW filter of the present invention includes:
a filter section composed of a first SAW resonator inserted into a signal path and a second SAW resonator provided between the above-described signal path and a ground; and
a circuit component composed of an inductor for shifting a resonant point/antiresonant point provided in series to the above-described first SAW resonator and/or an inductor for shifting a resonant point/antiresonant point provided in parallel to the above-described second SAW resonator and the above-described filter section, in which
the circuit components are cascade connected in two or more stages between an input port and an output port while inserting the inductor for shifting a resonant point/antiresonant point between the respective circuit components,
the above-described inductor contained in the circuit component on the above-described input port side is provided between the filter section of the circuit component and the input port, and
the above-described inductor contained in the circuit component on the output port side is provided between the filter section of the circuit component and the output port.

The above-described inductor inserted between the circuit components adjacent to each other is provided to be inserted into the signal path or between the signal path and the ground.

The SAW filter can be suitably used for a receiving section of a portable terminal making it possible to receive TV broadcasting, in which two antennas, antenna 1 for receiving digital TV broadcasting and antenna 2 for transceiving voice (and data) communication signals, are arranged closely to each other, as described above.

More concretely, the SAW filter of the present invention is used for a receiving section of a portable terminal provided with an antenna and the receiving section for receiving waves in the band range from 470 MHz to 710 MHz, and an antenna for transceiving waves in the band range from 830 MHz to 840 MHz. Alternatively, the SAW filter of the present invention is used for a receiving section of a portable terminal provided with an antenna and the receiving section for receiving waves in the band range from 470 MHz to 870 MHz, and an antenna for transceiving waves in the band range from 880 MHz to 915 MHz.

The portable terminal of the present invention includes:
an antenna and a receiving section for receiving waves for digital TV broadcast; and an antenna for transceiving voice and/or data for a portable terminal, in which
the SAW filter of the present invention is provided in the above-described receiving section.

As described above, the present invention pays attention to a structure in which constant-K (reverse L type) filters having a parallel arm and a series arm with a pair of SAW resonators are connected in a cascade connection, and at the same time, plans to solve a problem of not obtaining a wide passband by combining inductors, so that a BEF circuit having a large attenuation and a wide passband width with low loss can be realized. In particular, it is suitable for preventing transmitted waves in the TV tuner of the portable terminal with a digital TV broadcast receiver from interfering with the received waves of digital TV broadcasting.

### BRIEF DESCRIPTION OF THE DRAWINGS

FIG. 1 is a structural diagram of a transceiving section of a portable terminal with a digital TV broadcast receiver;
FIG. 2 shows a power ratio of the desired wave and the undesired wave of the portable terminal with a digital TV broadcast receiver;
FIG. 3 shows a structural example of a receiving system of a TV tuner module for digital broadcasting waves;
FIG. 4 shows examples of characteristics required for BEF circuits of the TV tuner for digital broadcasting waves;
FIGs. 5A, 5B and 5C are examples of structural diagrams of an equivalent circuit and a series circuit of a SAW resonator and the transmission characteristics of the above SAW filters;
FIGs. 6A and 6B are examples of a parallel circuit structure of a SAW resonator and transmission characteristics of the SAW filter;
FIGs. 7A and 7B are examples of a ladder type structure of the SAW resonators and the transmission characteristics thereof;
FIGs. 8A and 8B are examples of a series connection structure of an inductor with the SAW resonator and the transmission characteristics thereof;
FIGs. 9A and 9B are examples of resonance point shifting of the series connection structure of the inductor with the SAW resonator;
FIGs. 10A and 10B are examples of a parallel connection structure of an inductor with the SAW resonator and the transmission characteristics thereof;
FIGs. 11A and 11B are examples of resonance point shifting of the parallel connection structure of the inductor with the SAW resonator;
FIGs. 12A, 12B and 12C are examples of circuit diagrams of SAW filters showing the embodiments of the present invention and design constants;
FIGs. 13A and 13B show transmission characteristics in the present embodiments;
FIGs. 14A, and 14B are circuit diagrams of SAW filters showing other embodiments of the present invention;
FIGs. 15A and 15B show transmission characteristics in one of the above embodiments;
FIG. 16A and 16B show transmission characteristics in the other one of the above embodiments;
FIG. 17 is an example of the circuit diagram of the SAW filter showing still another embodiment of the present invention;
FIGs. 18A and 18B show transmission characteristics in the above embodiment;
FIG. 19 is an example of the circuit diagram of the SAW filter showing yet another embodiment of the present invention;
FIGs. 20A and 20B show transmission characteristics in the above embodiment;
FIG. 21 is a circuit diagram showing a modified example of the SAW filter of the present invention;
FIG. 22 is a circuit diagram showing another modified example of the SAW filter of the present invention;
FIGs. 23A and 23B are transmission characteristics in the above modified example in FIG. 21;
FIG. 24 is a circuit diagram showing still another modified example of the SAW filter of the present invention; and
FIGs. 25A and 25B are transmission characteristics in the above modified example.

### DETAILED DESCRIPTION OF THE PREFERRED EMBODIMENT(S)

The structure of conventional SAW filters and the filter characteristics shown by the filters will be explained hereinafter before explaining the embodiments of the present invention.

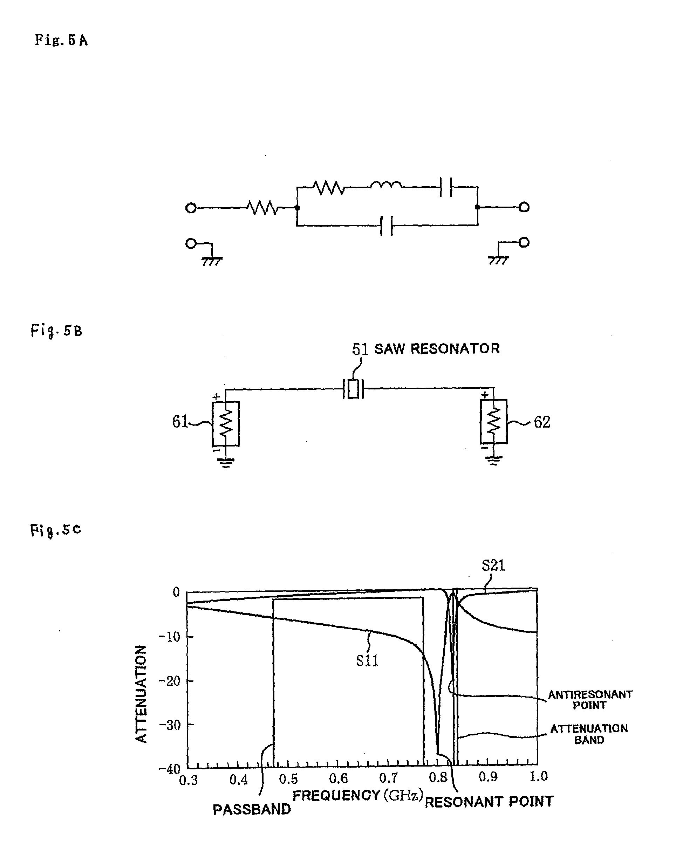

FIG. 5A shows an equivalent circuit of a SAW resonator. FIG. 5B is a series arm structure in which the SAW resonator is connected in series with an input terminal and an output terminal having respective terminal impedance of 50 Ω. FIG. 5C shows two-port transmission characteristics of the circuit shown in FIG. 5B. In the drawing, 51 indicates the series arm SAW resonator, and 61, 62 indicate the input port and the output port respectively. As shown in FIG. 5C, a SAW resonator usually has one resonant point and one antiresonant point, and the transmission characteristics of the SAW resonator can be obtained by putting a reflection characteristic S11 having the resonant point and a frequency response S21 having the antiresonant point together. In the case of FIG. 5C, the resonant point is positioned between a digital TV broadcast wave band (passband) and a transmitting wave band (stopping band), and the antiresonant point comes close to the transmitting wave band, so that interference caused by this can be reduced.

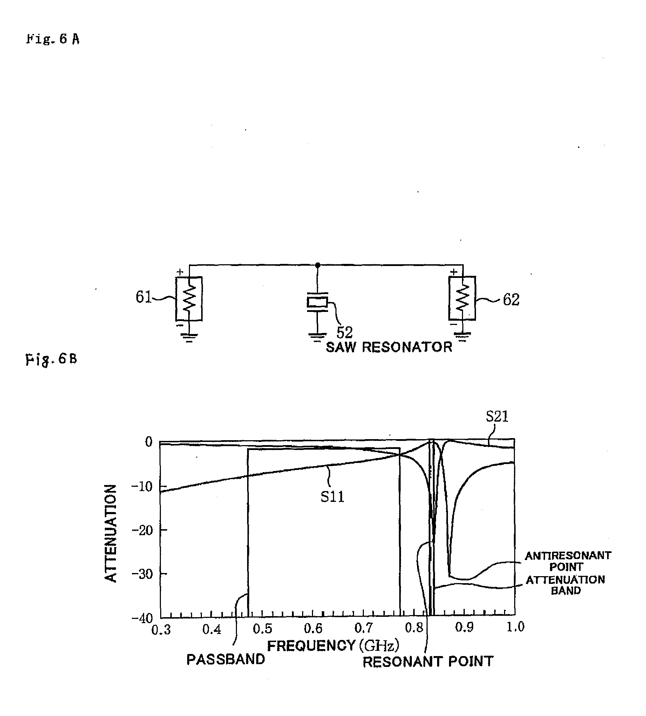

FIG. 6A is a parallel arm structure in which the SAW resonator is connected in parallel to the input terminal and the output terminal having respective terminal impedance of 50 Ω. FIG. 6B shows two-port transmission characteristics in this structure. In the drawing, 52 indicates a parallel arm SAW resonator. In this case, the structure also has one resonant point and one antiresonant point.

From the above, a SAW resonant can be used in a BEF circuit of a digital broadcast wave TV tuner. However, positions of the resonant point and the antiresonant point of the SAW resonator are limited by an electromechanical coupling coefficient or capacitance of a piezoelectric substrate used, and various design parameters. This limitation makes the freedom of design narrower and low loss in a wide range of band very difficult.

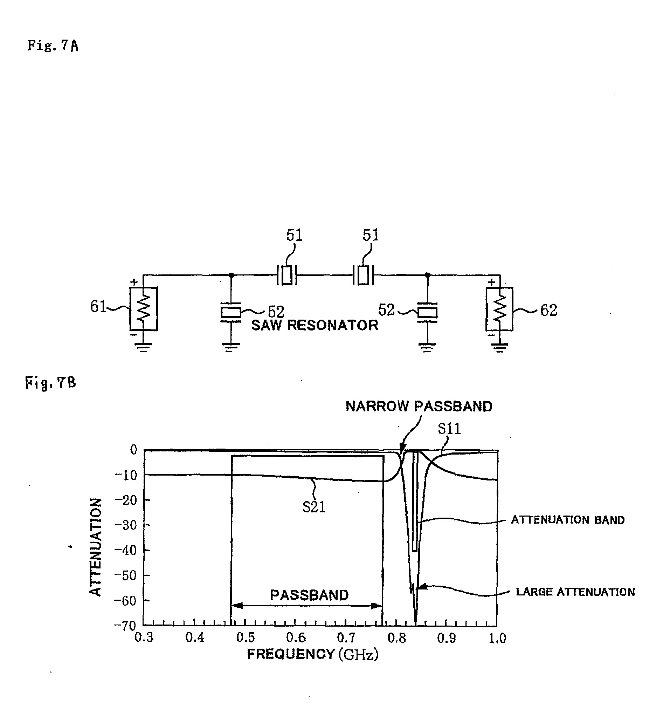

For instance, the attenuation in one SAW resonator is about 10 to 30 dB, and in order to obtain a large attenuation in the attenuation band, as shown in FIG. 7A, it is necessary to alternately connect a parallel arm SAW resonator 52 and a series arm SAW resonator 51, in other words, to connect in a ladder type. By this structure, as shown in an example of the characteristics in FIG. 7B, though a large attenuation can be expected, the passband at this time becomes extremely narrow. This is due to an electromechanical coupling coefficient of the SAW resonator. The attenuation band width and the attenuation can be increased by connecting the respective resonators, but the passband of low loss becomes narrow on the contrary.

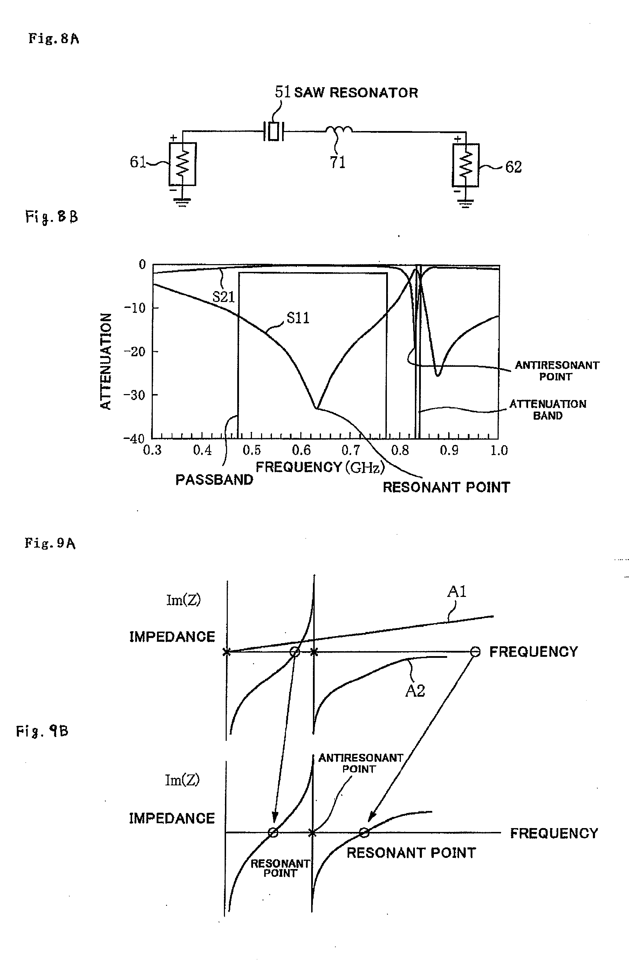

A SAW filter is structured by inserting an inductor 71 in series to the series arm SAW resonator 51 shown in FIG. 5 to obtain a wide pass band with low loss and a large attenuation in the stopping band, as a solution to solve such an inconvenience. FIG. 8A shows a SAW filter having such a structure, and FIG. 8B shows an example of the characteristics in this structure. The characteristics are as follows in this case. The resonant point shifts to a lower frequency side, so as to get matching in a wide band, and extremely low loss in the pass band.

FIG. 9A shows an analytical example of impedance characteristics in a single structure of the SAW resonator, and FIG. 9B shows an analytical example of impedance characteristics in a structure of inserting an inductor in series to the SAW resonator. A1 and A2 indicate impedance characteristics of the inductor and the SAW resonator respectively. The antiresonant point is not shifted by inserting the inductor in series to the SAW resonator, but the resonant point below the antiresonant point shifts further downward, and the resonant point degenerated to ∞ H_{Z} appears above the antiresonant point. The frequency at the resonant point can be shifted without restraint by the inductance value of the inductor.

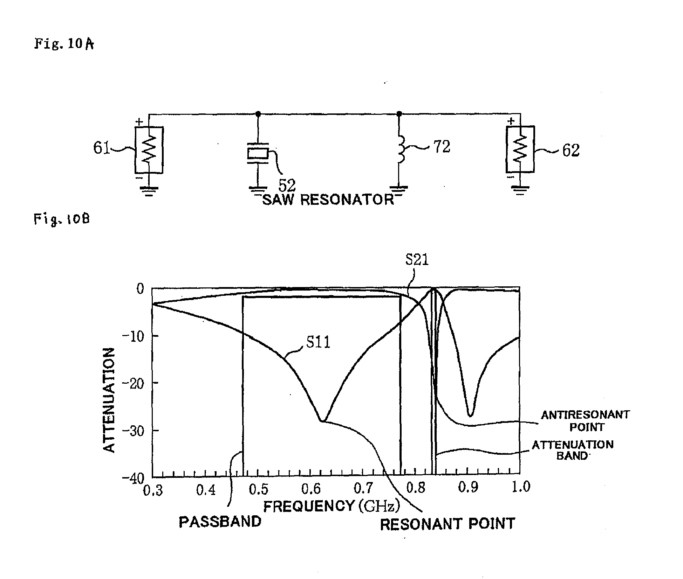

FIG. 10A shows a structure to insert an inductor 72 in parallel to the parallel arm SAW resonator 52 in FIG. 6A. FIG. 10B shows the characteristics in the case of this structure. The characteristics similarly show that matching is also possible in a wide range of the band and loss in the passband is extremely low.

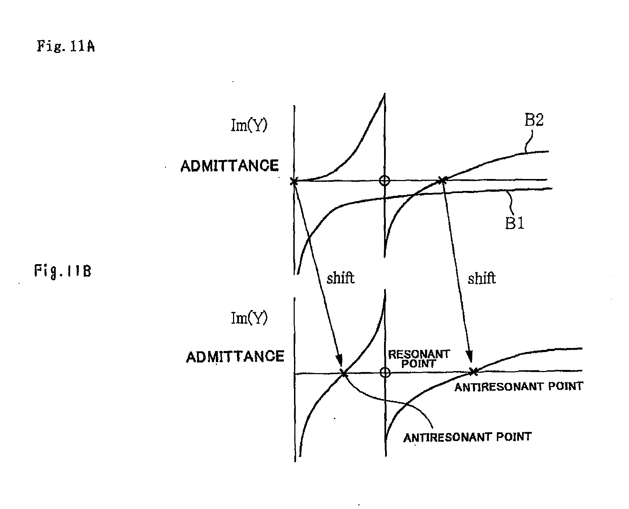

FIG. 11A shows an analytical example of admittance characteristics in a single structure of the SAW resonator, and FIG. 11B shows an analytical example of admittance characteristics in a structure of inserting an inductor in parallel to the SAW resonator. B1 and B2 indicate the admittance characteristic of the inductor and the SAW resonator respectively. The resonant point is not shifted by inserting the inductor in parallel to the SAW resonator, but the anti-resonant point above the resonant point shifts further upward, and the antiresonant point degenerated to 0 H_{Z} appears below the resonant point. The frequency at this antiresonant point can be shifted without restraint by the inductance value of the inductor.

The present invention have been achieved based on the above analysis and the experimental result. A constant-K (reverse L) filter is formed first with the series arm SAW resonator shown in FIG. 8A and the parallel arm SAW resonator shown in FIG. 10A. The inductor is arranged in series to the series arm SAW resonator, or in parallel to the parallel arm SAW resonator in this filter, and thus structured circuit components are subjected to a cascade connection in a plurality of stages via the inductors. By adopting such a structure, it is possible to realize a BEF circuit with a large attenuation, a wide passband width, and low loss.

FIG. 12A shows a case of two-stage structure as an embodiment of the present invention. In this example, a constant-K filter is formed with a SAW resonator 11 inserted in series to an input port 61 (inserted in a signal path connected to an input terminal 61a), and a SAW resonator 12 connected in parallel to the input port 61 (connected between the above-described signal path and the common ground) on the input port 61 side, which is an input signal application portion between the input terminal 61a and the common ground. These SAW resonators 11 and 12 are called a series arm SAW resonator 11 and a parallel arm SAW resonator 12 respectively. An inductor 13 is inserted in series to the series arm SAW resonator 11 on the opposite side of a connection point with the parallel arm SAW resonator 12, and an inductor 14 is provided in parallel to the parallel arm SAW resonator 12. Similarly, a constant-K filter is formed with a SAW resonator 15 inserted in series to an output port 62, and a SAW resonator 16 connected in parallel to the output port 62, on the output port 62 side which is an output signal taking-out portion between an output terminal 62a and the common ground. An inductor 17 is inserted in series to the SAW resonator 15 on the opposite side of a connection point to the parallel arm SAW resonator 16, and an inductor 18 is provided in parallel to the SAW resonator 16. These inductors 13 and 17 are connected to each other.

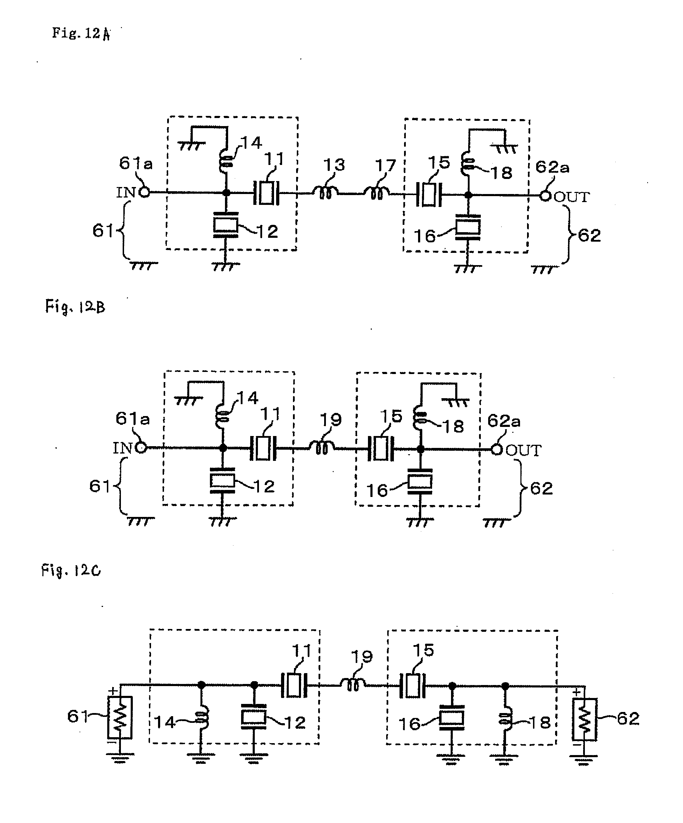

In this example, one circuit component is formed with the SAW resonators 11 and 12, and the inductors 13 and 14, and the other circuit component is formed with the SAW resonators 15 and 16, and the inductors 17 and 18. It should be noted that the portions surrounded by dotted lines correspond to the circuit component in the respective drawings. When these circuit components are connected in a cascade connection to each other, the inductor 13 connects with the inductor 17 in series. Accordingly, this structure is equivalent to a circuit structure in FIG. 12B, which includes an inductor 19 having the same inductance value with the sum of these inductance values in FIG. 12A.

The design constants of the SAW resonators and the inductors in the structure shown in FIG. 12C are as follows. As for the SAW resonators 12 and 16, the tap number is 200, the opening length is 23 λ (λ is a wavelength at the central frequency), and as for the SAW resonators 11 and 15, the tap number is 132, and the opening length is 28 λ. The inductance of the inductors 14 and 18 is 10 nH, the inductance of the inductor 19 is 20 nH, and both inductances use a coil having the frequency of Q value 50 per 1 GHz frequency.

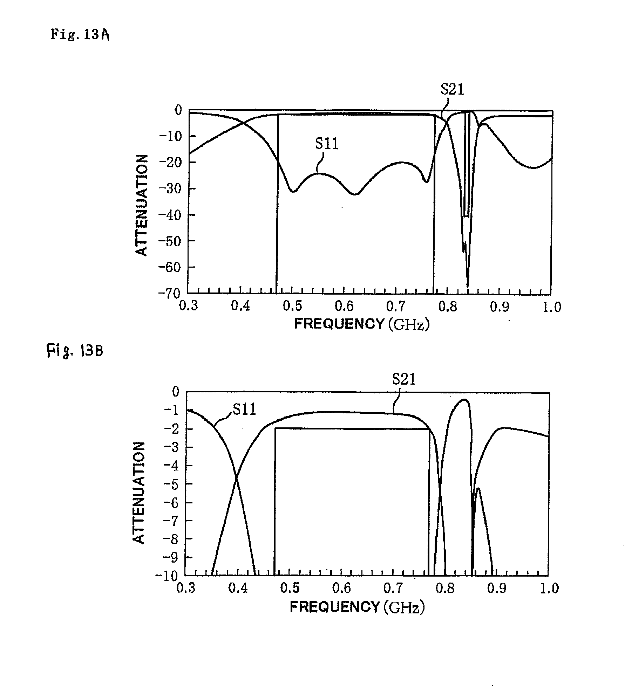

FIG. 13A shows the transmission characteristics in this circuit. FIG. 13B shows the transmission characteristics by an enlarged scale of the vertical axis (attenuation). As is made clear from the characteristic diagram, the transmission characteristics of large attenuations in the transmitting wave band (stopping band), and low loss and wide passband width in the receiving band of TV waves can be obtained, which is desirable as the BEF circuit for a digital broadcast wave TV tuner.

The reason why such desirable transmission characteristic are obtained is based on the following. That is, the embodiment of the present invention adjusts the resonant point and the antiresonant point by the inductor, and the digital broadcasting waves are allowed to pass through by placing the resonant point in the band range of the digital broadcasting waves or close thereto, while the antiresonant point is placed in the transmitting wave band or close thereto, so that transmitting waves coming into a broadcast wave TV tuner module are reflected.

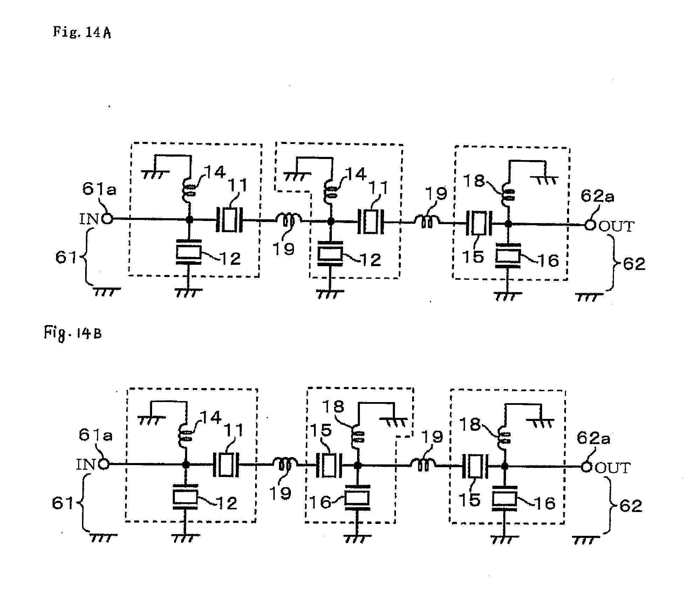

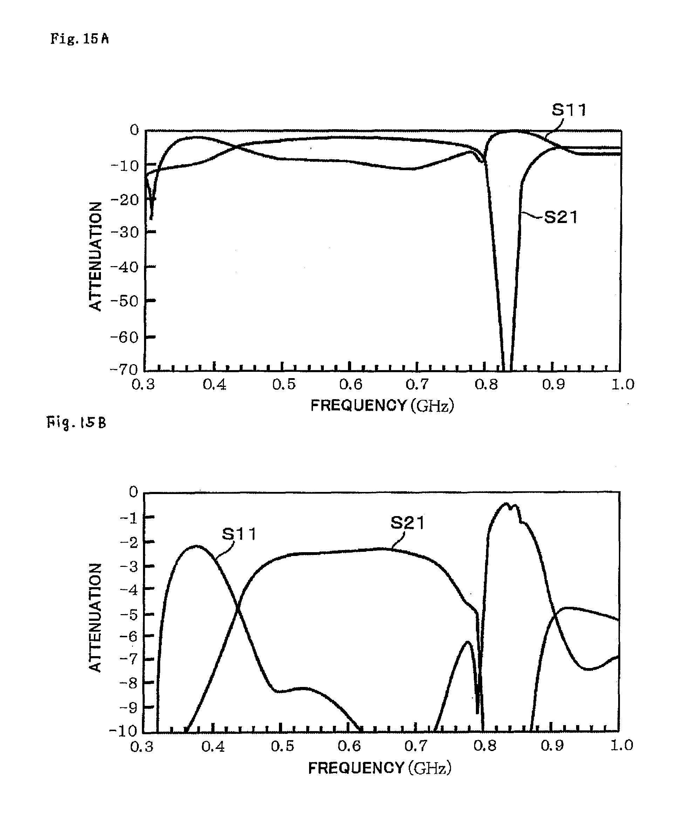

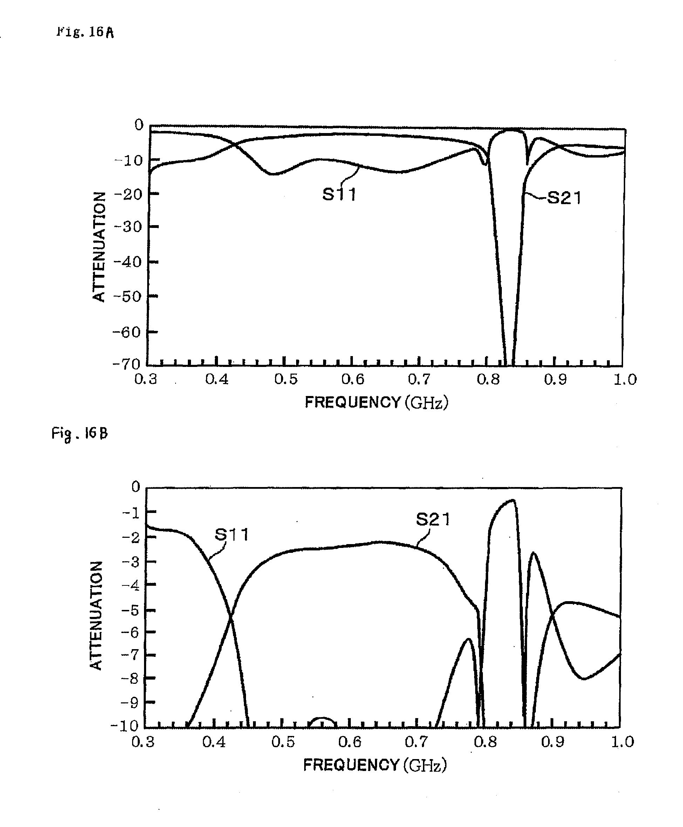

Though FIG. 12 shows the case of two-stage structure, it is possible to further enhance the attenuation of the stopping band by making it a multi-stage structure. FIGs. 14A and 14B show examples of three-stage structures respectively. FIG. 15A shows the transmission characteristics in the circuit structure in FIG. 14A, and FIG. 15B also shows the above transmission characteristics by an enlarged scale of the vertical axis (attenuation). FIG. 16A shows the transmission characteristics in the circuit structure in FIG. 14B, and FIG. 16B also shows the above transmission characteristics by an enlarged scale of the vertical axis (attenuation). As understood from these results, the transmission characteristics in the circuit structure shown in FIG. 14A and those shown in FIG. 14B are equivalent to each other. In other words, the SAW filters shown in FIGs. 12A, 12B, 12C, and FIGs. 14A, 14B are structured as follows. A constant-K filter is formed with the series arm SAW resonator 11 (15) and the parallel arm SAW resonator 12 (16), and then a circuit component is formed by further providing the inductor 14 (18) for shifting resonant point/antiresonant point in parallel to the above-described parallel arm SAW resonator 12 (16). The circuit components thus formed are connected in a cascade connection in two or more stages by inserting inductors for shifting resonant point/antiresonant point between the circuit components.

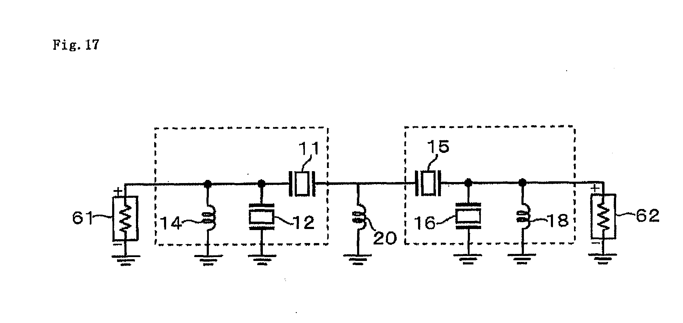

FIG. 17 shows another embodiment of the present invention. A portion different from FIGs. 12A, 12B and 12C in the drawing is to omit the inductor 19 inserted in series between the SAW resonator 11 and the SAW resonator 15, and to provide an inductor 20 in parallel at this portion. In other words, a circuit component is structured in such that an inductor is provided in parallel to the input port 61 on the opposite side of the connection point between the series arm SAW resonator 11 and the parallel arm SAW resonator 12, while an inductor is provided in parallel to the output port 62 on the opposite side of the connection point between the series arm SAW resonator 15 and the parallel arm SAW resonator 16, and the inductor 20 bears the parallel inductance values of both inductors.

The design constants of the SAW resonators and the inductors in the structure shown in FIG. 17 are as follows. As for the SAW resonators 12 and 16, the tap number is 176, the opening length is 24 λ, and as for the SAW resonators 11 and 15, the tap number is 121, and the opening length is 25 λ. The inductance of the inductors 14 and 18 is 8.2 nH while the inductance of the inductor 20 is 10 nH, and both inductances use a coil having the frequency of Q value 50 per 1 GHz.

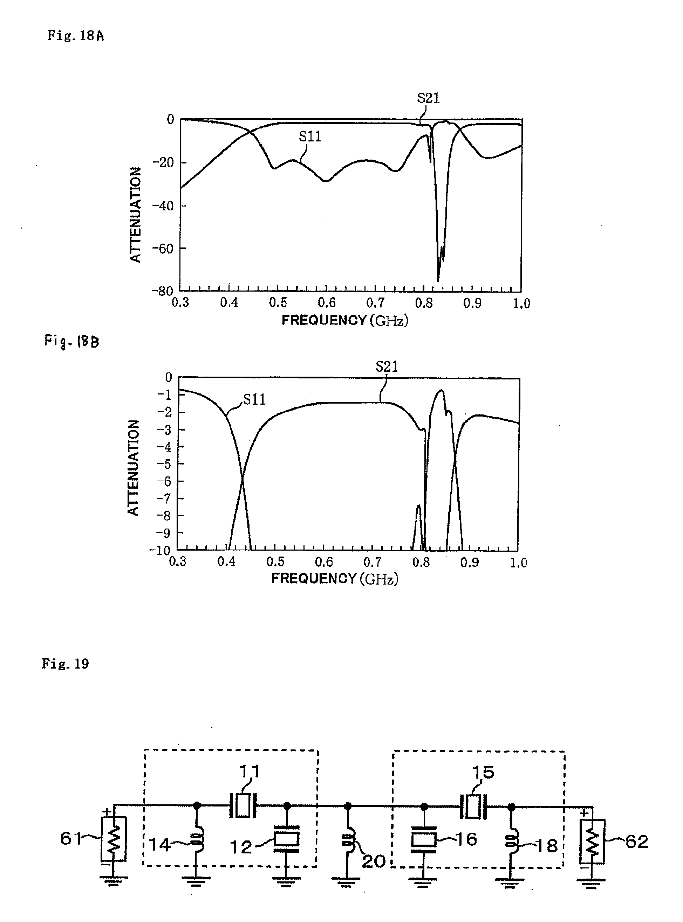

FIG. 18A shows the transmission characteristics in this circuit. FIG. 18B shows the transmission characteristics by an enlarged scale of the vertical axis (attenuation). The characteristics equivalent to the case in FIG. 12 can be obtained. It should be noted that the present embodiment can also take a multi-stage cascade connection structure of three or more stages, and it is not limited to a two-stage cascade connection.

FIG. 19 shows another embodiment of the present invention which is nearly the same as the circuit in FIG. 17. The difference of this example from the circuit in FIG. 15 is as follows. The series arm SAW resonator 11 is inserted between the parallel arm SAW resonator 12 and an inductor 14, and the series arm SAW resonator 15 is inserted between the parallel arm SAW resonator 16 and an inductor 18.

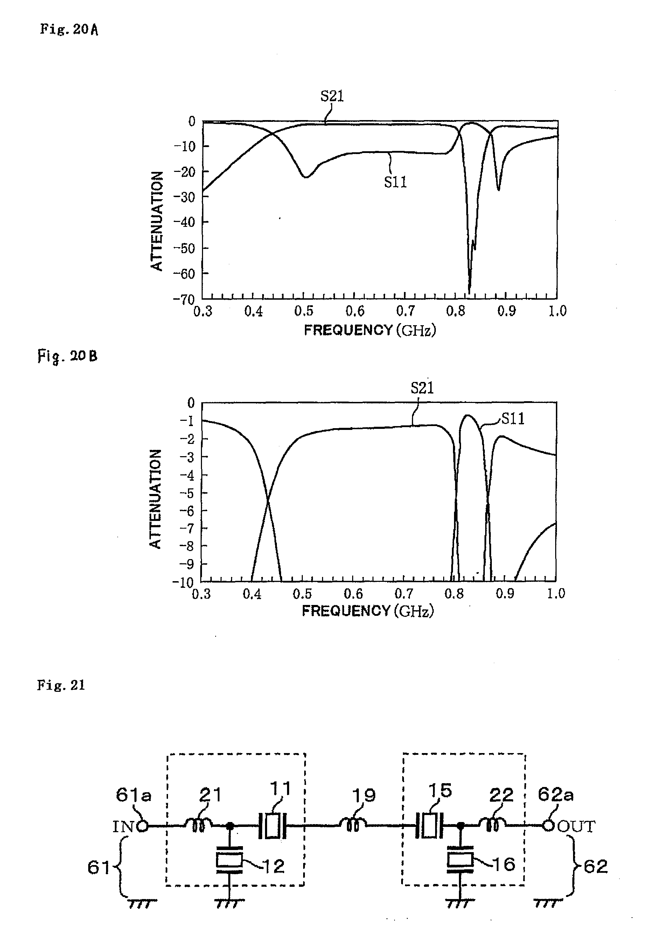

The design constants of the SAW resonators and the inductors in the structure shown in FIG. 19 are as follows. As for the SAW resonators 12 and 16, the tap number is 200, the opening length is 23 λ, and as for the SAW resonators 11 and 15, the tap number is 132, and the opening length is 28 λ. The inductance of the inductors 14 and 18 is 14 nH, the inductance of the inductor 20 is 4 nH, and both inductances use a coil having the frequency of Q value 50 per 1 GHz. FIG. 20A shows the transmission characteristics in this circuit, and FIG. 20B shows it by an enlarged scale of the vertical axis (attenuation). The characteristics equivalent to the case in FIG. 12 can be obtained.

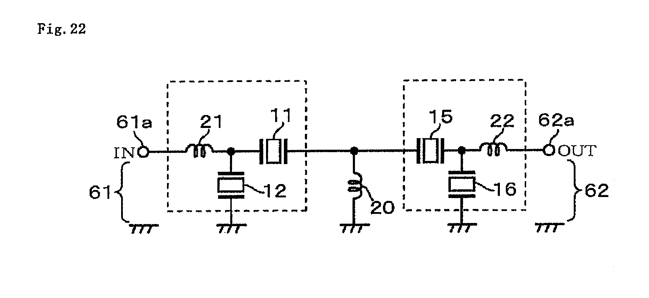

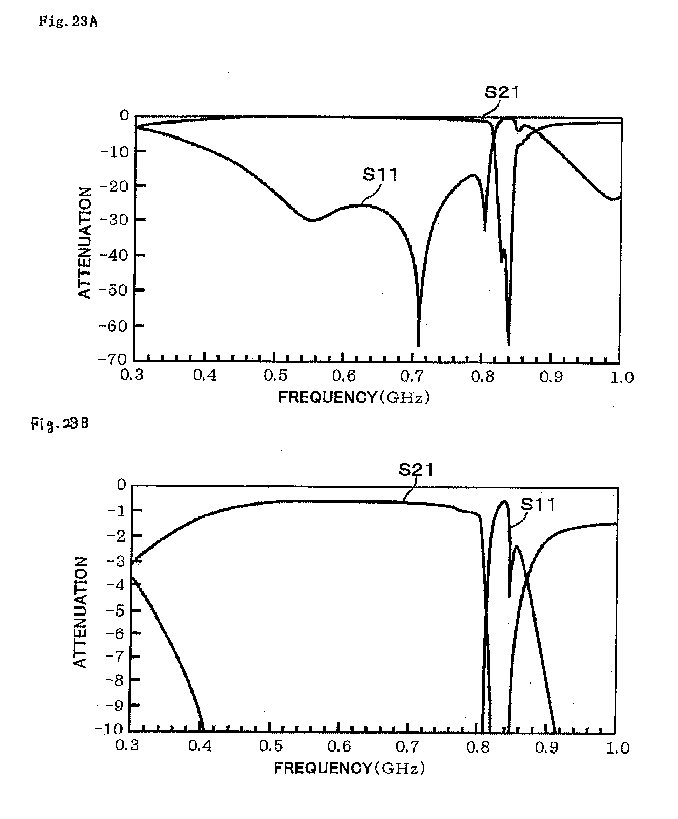

FIG. 21 and FIG. 22 show still other embodiments of the present invention. The SAW filter shown in FIG. 21 inserts inductors 21 and 22 in series to the input port 61 and the output port 62 respectively in place of the inductors 14 and 18 in the circuits in FIG. 12C. The SAW filter shown in FIG. 22 takes a structure such that inductors 21 and 22 are inserted in series to the input port 61 and the output port 62 respectively in place of the inductors 14 and 18 in the circuits in FIG. 17. By taking such a structure, it is possible to obtain the equivalent characteristics to those shown in FIGs. 12A, 12B, 12C or FIG. 17. FIG. 23A shows the transmission characteristics in FIG. 21, and FIG. 23B shows it by an enlarged scale of the vertical axis (attenuation). In the circuits shown in FIG. 21 and FIG. 22, the circuit components surrounded by dotted lines are not limited to a cascade connection in a two-stage structure, but may be a cascade connection in three or more-stage structure.

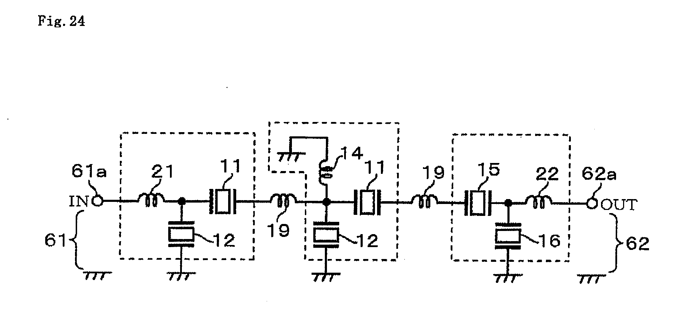

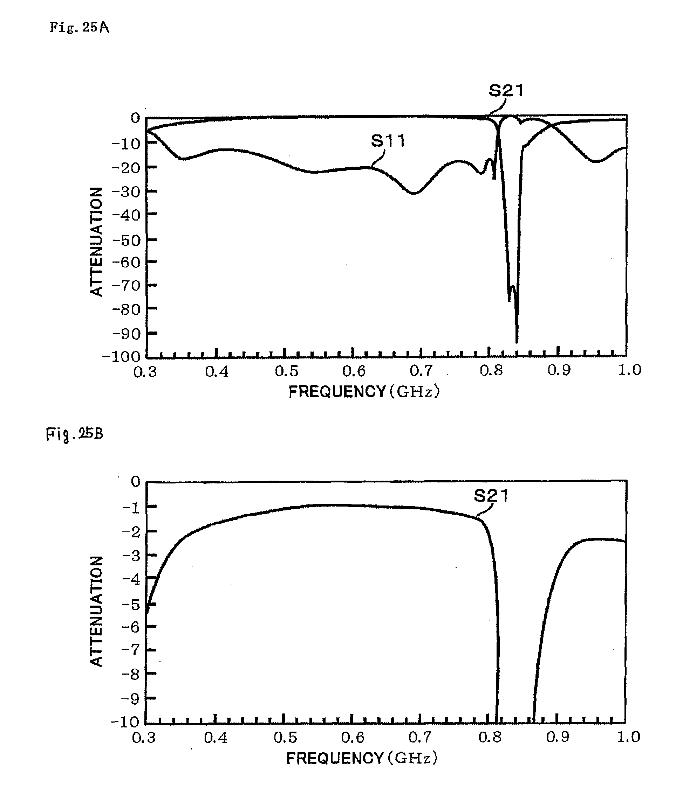

FIG. 24 shows still another embodiment of the present embodiment. The SAW filter of this example has the circuit component structured in cascade connection in three stages by inserting the circuit component shown in FIG. 14A between the two-stage circuit component shown in FIG. 21. It should be noted that as for the circuit constant, the circuit constant for obtaining the optimum characteristics is selected though there is no large difference from the circuit constant already described. FIG. 25A shows the transmission characteristics in the circuit structure in FIG. 24, and FIG. 25B shows it by an enlarged scale of the vertical axis (attenuation). The characteristics equivalent to the case in FIG. 12 can be obtained.

In the examples described above, a circuit component is structured with the series arm SAW resonator 11 (a first SAW resonator inserted in a signal path), the parallel arm SAW resonator 12 (a second SAW resonator provided between the signal path and the ground), and an inductor (for instance, 21) provided in series to the series arm SAW resonator 11 or an inductor (for instance, 14) provided in parallel to the parallel arm SAW resonator 12, but the inductors contained in the circuit component may be both the inductor (for instance, 21) provided in series to the series arm SAW resonator 11 and the inductor (for instance, 14) provided in parallel to the parallel arm SAW resonator 12.

The above-described SAW filters can be desirably used as a SAW BEF circuit (Band Elimination Filter circuit) in a receiving section of a portable terminal which is possible to receive TV broadcasting shown in FIG. 1 as described above. More concretely, they can be desirably used as a domestic use portable terminal which receives radio waves in the band range from 470 MHz to 710 MHz being digital TV broadcasting waves, and transceives radio waves ranging from 830 MHz to 840 MHz for voice or data communication, or a portable terminal for domestic use for beaming to Europe, which receives radio waves in the band range from 470 MHz to 870 MHz and transceives radio waves ranging from 890 MHz to 920 MHz.

In order to provide a SAW filter having a wide passband matching to the digital TV broadcast waves so as to be low-loss, and obtaining a sharp and large attenuation in the outside of the TV broadcast waves, a constant-K filter is composed of series arm SAW resonators and parallel arm SAW resonators, and a circuit component is formed by connecting an inductor for shifting a resonant point/antiresonant point to the series arm SAW resonator in series or to the parallel arm SAW resonator in parallel. A plurality of the circuit components are connected in a cascade connection to each other in a plurality of stages via inductors for shifting the resonant point/antiresonant point.

## Claims

1. A SAW filter comprising:
a filter section composed of a first SAW resonator inserted into a signal path and a second SAW resonator provided between said signal path and a ground;
a circuit component composed of an inductor for shifting a resonant point/antiresonant point provided in series to said first SAW resonator and/or an inductor for shifting a resonant point/antiresonant point provided in parallel to said second SAW resonator and said filter section, wherein
the circuit components are cascade connected in two or more stages between an input port and an output port while inserting the inductor for shifting a resonant point/antiresonant point between the respective circuit components;
said inductor contained in the circuit component on said input port side is provided between the filter section of the circuit component and the input port; and
said inductor contained in the circuit component on the output port side is provided between the filter section of the circuit component and the output port.

2. The SAW filter according to claim 1, wherein said inductor inserted between the circuit components adjacent to each other is provided to be inserted into the signal path.

3. The SAW filter according to claim 1, wherein said inductor inserted between the circuit components adjacent to each other is provided between the signal path and the ground.

4. The SAW filter according to claim 1, wherein the receiving band for digital television broadcast is established as a pass band, and the transmitting band for voice and/or data as a portable terminal is established as a stopping band.

5. The SAW filter according to claim 1, wherein said SAW filter is used for a receiving section of a portable terminal provided with an antenna and the receiving section for receiving radio waves in the band range from 470 MHz to 710 MHz and an antenna for transceiving radio waves in the band range from 830 MHz to 840 MHz.

6. The SAW filter according to claim 1, wherein said SAW filter is used for a receiving section of a portable terminal provided with an antenna and the receiving section for receiving radio waves in the band range from 470 MHz to 870 MHz and an antenna for transceiving radio waves ranging from 880 MHz to 915 MHz.

7. A portable terminal, comprising:
an antenna and a receiving section for receiving radio waves for digital television broadcast, and an antenna for transceiving voice and/or data for a portable terminal, wherein
the SAW filter according to claim 1 is provided in said receiving section.
